# EUROPÄISCHE PATENTANMELDUNG

(11) **EP 1 855 383 A2**
(43) Veröffentlichungstag der Anmeldung: **14.11.2007**
(21) Anmeldenummer: 07008819.0
(22) Anmeldetag: 02.05.2007
(51) Int. Cl.: H03M 1/12, G05B 1/02, H03M 1/46

(54) **A/D - Wandlerschaltung**

(30) Priorität: 09.05.2006 DE 102006021411
(71) Anmelder: Semikron Elektronik GmbH & Co. KG Patentabteilung, 90431 Nürnberg (DE)
(72) Erfinder: Königsmann, Gunter, 91058 Erlangen (DE)

(57) **Zusammenfassung**

Es wird eine A/D-Wandlerschaltung (10) mit einer Ansteuerlogik (12), einem D/A-Wandler (14), einem Komparator (16) und einem Multiplexer (18) beschrieben, wobei der Multiplexer (18) und der D/A-Wandler (14) an den Komparator (16) angeschlossen sind, die Ansteuerlogik (12) einen 8-Bit-Ausgang (30) aufweist, der an den D/A-Wandler (14) angeschlossen ist, der Komparators (16) an die Ansteuerlogik (12) angeschlossen ist, und der Multiplexer (18) an eine Anzahl Spannungsquellen (32, 34, 36, 38 ...) anschließbar ist, deren Spannungspegel auf Über- und Unterschreiten einer entsprechenden Schaltschwelle überwacht wird.

## Beschreibung

Die Erfindung betrifft eine A/D-Wandlerschaltung zur Überwachung einer Schalt- bzw. Spannungsschwelle.

Es sind verschiedene A/D-Wandler bekannt, bei denen es sich beispielsweise um Delta-Sigma-Wandler, um Pipeline-Wandler oder um Sukzessive-Approximations-Wandler - nachfolgend als SAR bezeichnet - handelt. Der Einsatz des jeweiligen Wandlers hängt von der geforderten Geschwindigkeit, den Kosten und der Genauigkeit ab. Zwischenzeitlich sind einige dieser Wandler derartig preisgünstig verfügbar, dass sie - am Eingang üblicherweise mit einem analogen Multiplexer versehen - in Mikrocontrollern, digitalen Signalprozessoren, Batterieüberwachungsschaltungen, Ladeschaltungen o. dgl. vorgesehen sind. Ein bekannter einfacher A/D-Wandler, wie er beispielsweise in preisgünstigen digitalen Voltmetern vorgesehen ist, ist dadurch realisierbar, dass eine Spannung aus einem D/A-Wandler oder aus einem RC-Glied hochgefahren und/oder heruntergefahren und verglichen wird, wann diese Spannung höher oder niedriger als das zu messende Spannungssignal wird.

Eine Erweiterung dieses bekannten Verfahrens mit einer signifikant erhöhten Wandlungsgeschwindigkeit ist dadurch erreichbar, dass die Referenzspannung, die mit dem zu messenden Spannungssignal verglichen wird, nicht in kleinstmöglichen Spannungsschritten erhöht wird, um messen zu können, wann genau die Referenzspannung erreicht bzw. höher als das zu messende Spannungssignal wird, sondern es wird in einem ersten Schritt eine Referenzspannung verwendet, die genau der Hälfte des Messbereiches entspricht, um zu entscheiden, in welcher der beiden Hälften des Messbereiches sich das zu messende Spannungssignal befindet. Anschließend wird eine zweite Referenzspannung verwendet, um zu testen, in welcher Hälfte dieses halbierten Messbereiches sich das zu messende Spannungssignal befindet. Diese Referenzspannungsschritte werden dann entsprechend wiederholt.

Beispielhaft benötigt ein 8-Bit-A/D-Wandler bei Anwendung dieses Sukzessiven-Approxiamtions-Verfahrens für eine Wandlung also nur acht Wandlungsschritte anstelle der sonst bis maximal 256 nötigen Schritte. Dieses Sukzessive-Approximations-Verfahren führt somit zu einer Zeitersparnis.

Einige bekannte elektronische Bausteine mit eingebautem A/D-Wandler enthalten zusätzlich zu einem Multiplexer, der mehrere Eingänge nacheinander mit dem Eingang des A/D-Wandlers verbindet, einen Sequenzer, um Messungen an einer entsprechenden Anzahl von Kanälen vornehmen zu können. Der Sequenzer wählt die Kanäle nacheinander an. Die besagten elektronischen Bausteine können außerdem einen Digitalkomparator enthalten, der das Ergebnis der A/D-Wandlung mit einem z.B. von einem Programm einer CPU vorgegebenen Wert vergleicht und bei Überschreiten oder Unterschreiten dieses Wertes ein Signal auslöst. Dies ermöglicht beispielhaft einem Mikrocontroller das Überwachen von Schaltschwellen für Eingangsspannungen ohne einen Verbrauch von Taktzyklen der CPU.

Der oben abgehandelte Stand der Technik lässt bezüglich der Wandlungsgeschwindigkeit jedoch noch Wünsche offen. Selbst wenn an einem einzigen oder an allen mit einem Sukzessive-Approximations-Wandler überwachten Eingängen nur eine einzige Schaltschwelle überwacht werden soll, ist zur Überwachung, ob die besagte Schaltschwelle überschritten wird, eine vollständige A/D-Wandlung pro Kanal erforderlich.

In Kenntnis dieser Gegebenheiten liegt der Erfindung die Aufgabe zugrunde, die Geschwindigkeit zu erhöhen, mit der ein SAR-Wandler das Überschreiten oder das Unterschreiten einer Mehrzahl von Spannungspegeln überwachen kann, ohne die Kosten für den SAR-Wandler durch eine Änderung des Analogteiles oder durch Einführung zusätzlicher Analogschaltungen zu erhöhen.

Diese Aufgabe wird erfindungsgemäß durch die Merkmale des Anspruches 1 d.h. mit einer A/D-Wandlerschaltung mit einer Ansteuerlogik, einem D/A-Wandler zur Generierung einer Referenzspannung, einen Komparator und einem Multiplexer gelöst, wobei der Multiplexer und der D/A-Wandler mit ihren Ausgängen an die Eingänge des Komparators angeschlossen sind, die Ansteuerlogik einen n-Bit-Ausgang aufweist, der an den D/A-Wandler angeschlossen ist, der Ausgang des Komparators an die Ansteuerlogik angeschlossen ist, und der Multiplexer an eine Anzahl Spannungsquellen anschließbar ist, deren Spannungspegel auf Überschreiten und Unterschreiten einer entsprechenden Schaltschwelle überwacht werden soll. Bei dem n-Bit-Ausgang kann es sich um einen 8-Bit-Ausgang handeln.

Die Erfindung weist den Vorteil einer Erhöhung der Reaktionszeit bzw. einer Reduktion der Wandlungsdauer eines SAR-Wandlers auf, weil eine Überwachung des Überschreitens einer Schaltschwelle von einem Eingang eines kostengünstigen SAR-Wandlers in nur einem einzigen A/D-Wandler-Taktzyklus erfolgt.

Erfindungsgemäß bildet die zu überwachende Schaltschwelle die Referenzspannung des D/A-Wandlers. Wenn also für einen A/D-Wandler-Kanal die Schaltschwelle, deren Überschreiten oder Unterschreiten der A/D-Wandler überwachen soll, zu Beginn der Wandlung bereits feststeht, ist es möglich, einfach diese Schaltschwelle als Vergleichsspannung zu verwenden und den Komparator des A/D-Wandlers entscheiden zu lassen, ob die Schaltschwelle überschritten ist oder nicht. Das ermöglicht in vorteilhafter Weise eine sehr schnelle Entscheidung, ob die Schaltschwelle überschritten ist und folglich eine zeitnahe Reaktion trotz des Einsatzes eines unveränderten Analogteiles eines preisgünstigen SARs.

Zweckmäßig kann es sein, wenn dem Multiplexer ein Sequenzer zugeordnet ist, der zum aufeinanderfolgenden Ansteuern einzelner Spannungsquellen vorgesehen ist. Durch eine derartige Ausbildung ist es möglich, denselben SAR-Wandler zur genauen Messung mehrerer Spannungen und/oder zur Überwachung mehrerer Schaltschwellen mit einer hohen Wiederholrate einzusetzen.

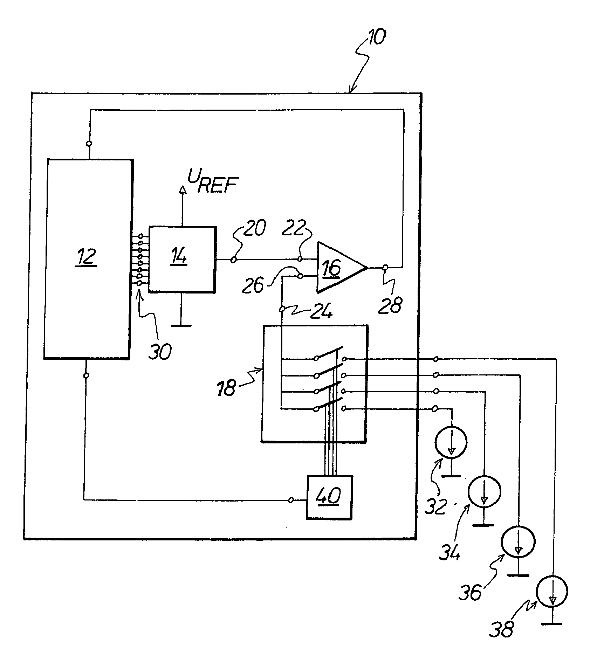

Weitere Einzelheiten, Merkmale und Vorteile ergeben sich aus der nachfolgenden Beschreibung eines in der Zeichnung dargestellten Ausführungsbeispieles der A/D-Wandlerschaltung in einer Blockdiagrammdarstellung.

Die Figur zeigt die A/D-Wandlerschaltung 10 mit einer Ansteuerlogik 12, einem D/A-Wandler 14, einem Komparator 16 und einem Multiplexer 18. Der D/A-Wandler 14 dient zur Generierung einer Vergleichsspannung aus der Referenzspannung U_{REF} und ist mit seinem Ausgang 20 an einen Eingang 22 des Komparators 16 angeschlossen. Der Multiplexer 18 ist mit seinem Ausgang 24 an einen Eingang 26 des Komparators 16 angeschlossen. Der Komparator 16 weist einen Ausgang 28 auf, der an die Ansteuerlogik 12 angeschlossen ist.

Die Ansteuerlogik 12 weist einen 8-Bit-Ausgang 30 auf, der an den D/A-Wandler 14 angeschlossen ist. Der 8-Bit-Ausgang 30 dient zur Darstellung der natürlichen Zahlen k von 0 bis 255. Die am Ausgang 20 des D/A-Wandlers 14 gegebene Spannung ist durch (k : 256) x U_{REF} gegeben.

Der Multiplexer 18 ist an eine Mehrzahl Spannungsquellen 32, 34, 36, 38, ... anschließbar, deren Spannungspegel auf Überschreiten oder Unterschreiten ihrer Schaltschwellen überwacht wird. Zum aufeinanderfolgenden Ansteuern der einzelnen Spannungsquellen 32, 34, 36, 38, ... ist dem Multiplexer 18 ein Sequenzer 40 zugeordnet. Der Sequenzer 40 ist mit der Ansteuerlogik 12 zusammengeschaltet.

Ebenso ist es möglich, einzelne Spannungsquellen gemäß dem Stand der Technik auszuwerten und ihren Spannungspegel zu bestimmen.

### Bezugsziffernliste:

- 10: A/D-Wandlerschaltung
- 12: Ansteuerlogik (von 10)
- 14: D/A-Wandler (von 10)
- 16: Komparator (von 10)
- 18: Multiplexer (von 10)
- 20: Ausgang (von 14)
- 22: Eingang (von 16)
- 24: Ausgang (von 18)
- 26: Eingang (von 16)
- 28: Ausgang (von 16)
- 30: 8-Bit-Ausgang (von 12)
- 32: Spannungsquelle
- 34: Spannungsquelle
- 36: Spannungsquelle
- 38: Spannungsquelle
- 40: Sequenzer (von 10 für 18)

## Patentansprüche

1. A/D-Wandlerschaltung mit einer Ansteuerlogik (12), einem D/A-Wandler (14), einem Komparator (16) und einem Multiplexer (18), wobei der Multiplexer (18) und der D/A-Wandler (14) mit ihren Ausgängen (24, 20) an die Eingänge (26, 22) des Komparators (16) angeschlossen sind, die Ansteuerlogik (12) einen n-Bit-Ausgang (30) aufweist, der an den D/A-Wandler (14) angeschlossen ist, der Ausgang (28) des Komparators (16) an die Ansteuerlogik (12) angeschlossen ist, und der Multiplexer (18) an eine Mehrzahl Spannungsquellen (32,34, 36, 38 ...) anschließbar ist, deren Spannungspegel auf Überschreiten und Unterschreiten einer entsprechenden Schaltschwelle überwacht wird.

2. A/D-Wandlerschaltung nach Anspruch 1,
**dadurch gekennzeichnet,**
**dass** die zu überwachende Schaltschwelle die Referenzspannung des D/A-Wandlers (14) bildet.

3. A/D-Wandlerschaltung nach Anspruch 1,
**dadurch gekennzeichnet,**
**dass** dem Multiplexer (18) ein Sequenzer (40) zugeordnet ist, der zum aufeinanderfolgenden Ansteuern der einzelnen Spannungsquellen (32, 34, 36, 38 ...) vorgesehen ist.

4. A/D-Wandlerschaltung nach Anspruch 1,
**dadurch gekennzeichnet,**
**dass** mindestens eine Spannungsquelle derart überwacht wird, dass ihr Spannungspegel bestimmt wird.
